**Europäisches Patentamt**

(19) **European Patent Office**

**Office européen des brevets**

(11) Numéro de publication: **0 256 914**
**B1**

(12) **FASCICULE DE BREVET EUROPEEN**

(45) Date de publication du fascicule du brevet:
22.11.90

(21) Numéro de dépôt: **87401737.9**

(22) Date de dépôt: **24.07.87**

(51) Int. Cl.⁵: **H03K 3/57,** H03K 5/01,
G01S 7/28

(54) Circuit de contrôle du front d'établissement de l'impulsion de puissance appliquée à un magnétron.

(30) Priorité: **28.07.86 FR 8610894**

(43) Date de publication de la demande:
**24.02.88 Bulletin 88/8**

(45) Mention de la délivrance du brevet:
**22.11.90 Bulletin 90/47**

(84) Etats contractants désignés:
**DE GB IT SE**

(56) Documents cités:
**DE-B- 1 093 410**
**FR-A- 1 313 859**
**FR-A- 2 590 745**
**GB-A- 2 116 799**
**GB-A- 2 135 547**
**US-A- 2 697 171**
**US-A- 3 454 839**

**WESTERN ELECTRIC - TECHNICAL DIGEST,**
**no. 12, octobre 1968, pages 25-26, New York, US; R.K.**
**VAN WEELDEN: "Capacitive voltage reducer"**

(73) Titulaire: **LE CENTRE THOMSON D'APPLICATIONS**
**RADARS - LCTAR, 173, bld Haussmann,**
**F-75008 Paris(FR)**

(72) Inventeur: **Le Ray, François, THOMSON-CSF**
**SCPI 19, avenue de Messine, F-75008 Paris(FR)**

(74) Mandataire: **Albert, Claude et al, THOMSON-CSF SCPI,**
**F-92045 PARIS LA DEFENSE CEDEX 67(FR)**

## Description

La présente invention se rapporte à un circuit de contrôle du front d'établissement de l'impulsion de puissance appliquée à un magnétron.

Les magnétrons sont des tubes fréquemment utilisés en raison de leur robustesse, spécialement dans les émetteurs de radars à impulsions. En particulier, les magnétrons coaxiaux sont réputés pour leur haute stabilité de fréquence d'oscillation.

Cependant, tous les magnétrons, et en particulier les magnétrons coaxiaux, ont une tendance à osciller dans un mode autre que le mode désiré. Ceci est dû principalement à un problème de démarrage d'oscillation qui entraîne une forte gigue de temps sur l'impulsion émise. On a remarqué que la pente du front de l'impulson de tension appliquée sur sa cathode au moment où le tube commence à osciller est un facteur essentiel pour que le tube oscille correctement sur son mode fondamental. Cette pente ne doit pas, à cet instant-là, avoir une valeur trop élevée.

L'impulsion de tension appliquée à la cathode du tube est obtenue de manière connue à la sortie d'un transformateur d'impulsion. On peut contrôler, dans une certaine mesure, la pente de l'impulson en adoptant des valeurs déterminées de capacité distribuée et d'inductance de fuite pour le transformateur. Mais, ceci se traduit par le stockage d'une énergie trop importante dans le transformateur, d'où une perte de rendement et un échauffement indésirable des composants.

Sur les tubes à moyenne et forte puissance, on est donc obligé d'élaborer une impulson à deux pentes pour conserver un rendement convenable de l'émetteur à magnétron. Une solution connue et particulièrement intéressante consiste à connecter une charge élevée à la sortie du transformateur lorsque la tension atteint environ soixante-quinze pour cent de la tension de crête, ce qui infléchit la pente du front d'établissement et permet de ne pas ajouter une gigue de temps supplémentaire si on contrôle avec précision le point d'inflexion.

Une telle solution est décrite, par exemple, dans le livre "Radar transmitters" de George W. EWELL, McGraw-Hill Book Company, 1981, pages 122 à 124. Cette solution consiste à connecter à la sortie du transformateur une série de condensateurs en parallèle avec une résistance et un empilage de diodes Zener pour fixer la tension de charge normale des condensateurs en dehors des impulsions. Cet ensemble est relié à la sortie du transformateur par l'intermédiaire d'un empilage de diodes qui ne deviennent conductrices que lorsque la tension à la sortie du transformateur devient supérieure, en valeur absolue, à celle de charge normale des condensateurs, celle-ci étant fixée à une valeur prédéterminée, voisine de soixante-quinze pour cent de la tension de crête de l'impulsion. Les condensateurs se chargent alors jusqu'à une tension voisine de la tension de crête ce qui infléchit la pente de l'impulsion. Dès que la tension d'impulsion retombe, les diodes se bloquent et les condensateurs vont se redécharger jusqu'à la valeur de charge normale à travers les diodes Zener et la résistance.

Ce dispositif a cependant un premier inconvénient qui est que, la décharge des condensateurs s'effectuant dans une résistance, la constante de temps de l'ensemble est adaptée à une période de répétition donnée puisque le circuit doit avoir eu le temps de récupérer son état normal entre deux impulsions. Ce circuit n'est donc pas adaptable facilement à des périodes de répétition variables. D'autre part, un second inconvénient est qu'une partie de l'énergie est dissipée dans une résistance d'où une perte de rendement.

Il est connu par ailleurs par WESTERN ELECTRIC TECHNICAL DIGEST, n° 12, octobre 1968 pages 25–26 «Capacitive voltage reducer» de R. K. VAN WEELDEN, d'associer des condensateurs par un réseau de diodes de manière à assurer successivement la connexion en série des condensateurs pour les charger et leur connexion en parallèle pour les décharger.

Un objet de la présente invention est un circuit de contrôle faisant usage d'une association similaire et reposant sur des principes généraux identiques à ceux décrits dans le livre «Radar transmitters» cité ci-dessus mais ne présentant pas les inconvénients mentionnés, grâce en particulier à l'utilisation d'une source de haute tension positive à la place de diodes Zener pour fixer la tension de charge normale des condensateurs.

Selon l'invention, il est prévu un circuit de contrôle du front d'établissement de l'impulsion de puissance appliquée à un magnétron, comprenant un transformateur d'impulsion pour fournir ladite impulsion de puissance et un dispositif connecté à la sortie dudit transformateur pour infléchir la pente de ladite impulsion à partir d'une valeur prédéterminée de la tension sur cette sortie, ce dispositif comportant $n$ condensateurs et des moyens de commutation pour connecter en parallèle sur la sortie dudit transformateur lesdits condensateurs en série lorsque l'amplitude de l'impulsion de puissance atteint ladite valeur prédéterminée, ledit circuit de contrôle étant caractérisé en ce qu'il comporte une source de haute tension positive avec un condensateur réservoir à ses bornes, des premiers moyens pour connecter, en parallèle sur la sortie du transformateur, lesdits $n$ condensateurs en série dès que la tension sur cette sortie devient inférieure à ladite valeur prédéterminée et jusqu'à ce qu'elle atteigne sa valeur crête, des deuxièmes moyens pour connecter lesdits $n$ condensateurs en parallèle entre la source de haute tension positive et la sortie du transformateur dès que la tension de sortie lors du front arrière de l'impulsion devient supérieure à une seconde valeur prédéterminée, pour permettre la décharge des condensateurs, et des troisièmes moyens pour limiter la tension de rebondissement, survenant à la fin du front arrière de l'impulsion, à une troisième valeur prédéterminée et arrêter ainsi la décharge des $n$ condensateurs à une valeur de charge égale à la différence entre la tension de la source de haute tension positive et ladite troisième valeur prédéterminée.

L'invention sera mieux comprise et d'autres caractéristiques et avantages apparaîtront à l'aide de la description ci-après et des dessins joints où:

- la figure 1 représente le schéma d'un circuit de contrôle connu ;
- la figure 2 représente le schéma du circuit de contrôle selon l'invention, et
- la figure 3 est un diagramme de l'impulsion de puissance fournie par le circuit de la figure 2.

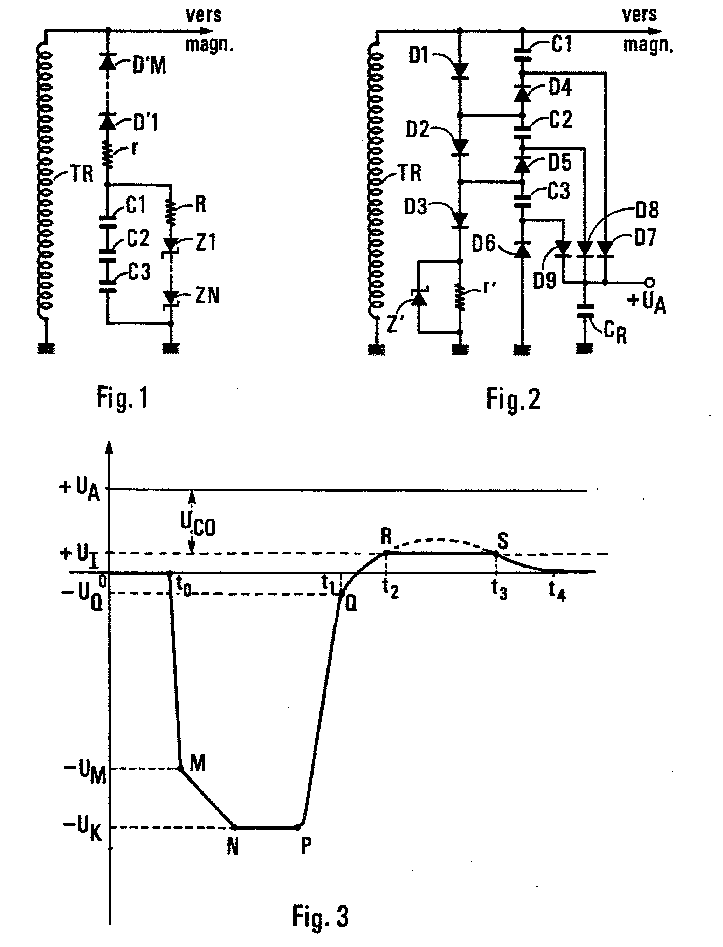

Sur la figure 1, est représenté le schéma du circuit de contrôle du front d'établissement de l'impulsion de puissance décrit dans l'ouvrage cité ci-dessus. Un transformateur d'impulsion TR reçoit l'impulsion et, après élévation de tension, l'applique entre la masse et la cathode du magnétron. Le circuit de contrôle connecté à la sortie du transformateur comprend les condensateurs C1 à C3 en série, avec en parallèle une résistance R et un empilage de diodes Zener Z1 à ZN. Cet ensemble est connecté entre la masse et la sortie du transformateur par une résistance $r$ en série avec un empilage de diodes D'1 à D'M. Lors de l'établissement de l'impulsion de haute tension négative sur la sortie du transformateur, tant que la tension de sortie est supérieure à la valeur de charge normale des condensateurs, les diodes D'1 à D'M sont bloquées. La valeur de charge normale est déterminée par la somme des tensions des diodes Zener Z1 à ZN qui définit la valeur en deçà de laquelle les condensateurs ne se déchargent sensiblement plus dans la résistance R.

L'établissement de l'impulsion s'effectue donc d'abord comme s'il n'y avait aucun circuit connecté à la sortie du transformateur. Dès que la tension d'impulsion devient inférieure à la valeur de charge des condensateurs, les diodes D'1 à D'M deviennent conductrices et on connecte ainsi le circuit des condensateurs, des diodes Zener et de la résistance R en parallèle sur la sortie du transformateur. Ceci infléchit la pente du front de l'impulsion, jusqu'à ce qu'on atteigne la valeur crête de l'impulsion. La charge des condensateurs en série a alors atteint cette valeur crête de sorte que peu de courant parcourt les diodes. Dès qu'on atteint le front arrière de l'impulsion, les diodes D'1 à D'M se bloquent et les condensateurs vont se décharger dans la résistance R pour reprendre leur valeur de charge normale.

On constate que, pendant toute la durée de l'impulsion à sa valeur crête, du courant circule dans les résistances R et $r$ provoquant des pertes d'énergie de même que pendant la décharge des condensateurs, ce qui nuit au rendement de l'ensemble. Par ailleurs, la décharge des condensateurs à travers la résistance R se fait avec une certaine constante de temps qui fait que le circuit est adapté à une période de répétition donnée et est difficilement utilisable lorsqu'on prévoit des impulsions non récurrentes.

La figure 2 est le schéma du circuit de contrôle selon l'invention. On utilise ici aussi des condensateurs C1 à C3 qui sont connectés en série à la sortie du transformateur TR pour être chargés dès que la tension d'impulsion atteint une valeur prédéterminée. Pour cela, on forme des cellules en série entre la sortie du transformateur et la masse, ces cellules étant formées chacune d'un condensateur, C1 à C3, et d'une diode, D4 à D6, en série. La cathode des diodes, D4 à D6, est reliée au condensateur de la cellule correspondante, le condensateur C1 de la première cellule étant relié à la sortie du transformateur et l'anode de la diode D6 de la dernière cellule étant reliée à la masse. Par ailleurs, il est prévu une source de haute tension positive +$U_A$, en parallèle avec un condensateur réservoir $C_R$. Cette source peut être la haute tension d'alimentation de l'ensemble de l'émetteur, dans le cas d'un émetteur radar, le condensateur $C_R$ étant alors une capacité de filtrage de l'alimentation. Cette source de haute tension est reliée aux cathodes des différentes diodes D4 à D6 par des diodes D7 à D9 dont la cathode est reliée à la source +$U_A$. Des diodes D1,D2 sont connectées respectivement en parallèle aux bornes des deux premières cellules (en fait, aux bornes des $n$-1 premières cellules si $n$ est le nombre de cellules), l'anode de chacune de ces diodes étant reliée à la borne de la cellule correspondante, côté condensateur. Enfin, en parallèle sur la dernière cellule, est connecté un circuit de limitation comprenant une diode D3 en série avec une diode Zener Z' et une résistance r' en parallèle.

Le fonctionnement de l'ensemble va être expliqué en se reportant également à la figure 3. On suppose qu'entre les impulsions, lorsque la tension de sortie du transformateur est nulle, les condensateurs conservent chacun une charge $U_{CO}$ inférieure à la tension $U_A$, ainsi qu'on le vérifiera ultérieurement. Aucune des diodes D1 à D9 n'est alors conductrice. Au temps $t_0$ débute le front d'établissement de l'impulsion. Jusqu'au point M (figure 3) correspondant à une tension -$U_M$ prédéterminée de l'ordre de soixante-dix à soixante-quinze pour cent de la valeur crête -$U_K$ de l'impulsion et égale à 3 $U_{CO}$ (ou n $U_{CO}$ s'il y a $n$ condensateurs), la tension s'accroît négativement comme si le transformateur n'était relié qu'à la cathode du magnétron. Dès qu'on atteint le point M, les diodes D4 à D6 deviennent toutes conductrices, tandis que les diodes D1 à D3 et D7 à D9 restent bloquées. Ainsi,entre les points M et N du front d'établissement, le transformateur assure la charge des condensateurs C1 à C3 jusqu'à ce qu'on atteigne la valeur crête -$U_K$. La pente du front d'établissement s'est infléchie et est égale à :

$$\frac{dV}{dt} = \frac{I}{C_\acute{e}}$$

où I est le courant de charge débité par le transformateur et $C_\acute{e}$ est la capacité équivalente à celle des condensateurs C1 à C3 en série.

Entre les points N et P qui correspondent à la poursuite du fonctionnement du magnétron, il n'y a plus de charge des condensateurs C1 à C3 qui conservent chacun la charge

$$\frac{U_K}{3}$$

s'ils sont identiques.

Dès que l'on arrive au front arrière de l'impulsion, les diodes D6 à D4 se bloquent successivement pour interdire toute décharge des condensateurs C1 à C3. Entre les points P et Q, le front arrière de l'impulsion s'établit comme si aucun circuit n'était connecté à la sortie du transformateur. A partir d'une valeur prédéterminée $-U_Q$ de la tension, correspondant au point Q (au temps $t_l$) de la courbe de la figure 3 et égale à la différence entre la charge de chaque condensateur et la tension $+U_A$, les diodes D7 à D9 et D1, D2 sont conductrices et les condensateurs C1 à C3 sont reliés en parallèle entre la sortie du transformateur et la source $+U_A$ et se déchargent au fur et à mesure que la tension de sortie du transformateur croît. La décharge s'effectue à travers la source de haute tension $+U_A$. Du fait du rebondissement de tension causé par le transformateur, la tension sur la sortie du transformateur dépasse la valeur zéro et croît positivement. A partir de la valeur zéro, la diode D3 se débloque et un courant commence à traverser la résistance r'. La tension sur la sortie du transformateur croît jusqu'au temps $t_2$, où la tension atteint une troisième valeur prédéterminée $+U_l$ (point R de la courbe) qui est la tension de limitation de la diode Zener Z'. A partir de cet instant cette diode Zener interdit à la tension de sortie de croître davantage. La décharge des condensateurs C1 à C3 s'arrête donc à la valeur :

$$U_{CO} = U_A - U_l$$

Du temps $t_2$ au temps $t_3$ (points R à S), la tension est limitée à $+U_l$ et de l'énergie est dissipée dans la résistance r'. A partir du point S, la tension de sortie du transformateur retombe en dessous de $+U_l$, la diode Zener Z' cesse de conduire, les diodes D7 à D9 se bloquent, interdisant toute décharge des condensateurs, et les diodes D1 à D3 conduisent pour permettre à l'énergie encore fournie par le transformateur de se dissiper dans la résistance r'.

Entre les temps $t_3$ et $t_4$ (figure 3), on a donc une portion de courbe de décharge d'un enroulement dans une résistance. Au temps $t_4$, la tension est revenue à zéro et le circuit est prêt pour l'impulsion suivante.

Ainsi, comme on le voit, la décharge des condensateurs ne s'effectue pas à travers une résistance et le circuit a un temps de récupération très court permettant le fonctionnement avec des impulsions non récurrentes. La limitation de la tension de rebondissement permet de fixer avec précision la charge résiduelle $U_{CO}$ des condensateurs, donc le point M. En effet, la tension $+U_A$ et la tension $+U_l$ sont choisies de façon que :

$$-U_M = -n \, U_{CO} = -n \, (U_A - U_l)$$

si $n$ est le nombre de condensateurs.

On peut remarquer que l'on pourrait limiter la tension de rebondissement par tout autre moyen équivalent au circuit diode Zener-résistance en parallèle, par exemple par une source de tension d'alimentation $+U_l$ remplaçant le circuit Z', r'.

Grâce au fait que l'essentiel de l'énergie stockée dans le transformateur et de l'énergie de décharge des condensateurs C1 à C3 est restitué à la source d'alimentation haute tension, on obtient un rendement très amélioré.

Bien entendu, l'exemple de réalisation décrit n'est nullement limitatif de l'invention.

## Revendications

1. Circuit de contrôle du front d'établissement de l'impulsion de puissance appliquée à un magnétron, comprenant un transformateur l'impulsion pour fournir ladite impulsion de puissance et un dispositif connecté à la sortie dudit transformateur pour infléchir la pente de ladite impulsion à partir d'une valeur prédéterminée de la tension sur cette sortie, ce dispositif comportant $n$ condensateurs et des moyens de commutation pour connecter en parallèle sur la sortie dudit transformateur lesdits condensateurs en série lorsque l'amplitude de l'impulsion de puissance atteint ladite valeur prédéterminée, ledit circuit de contrôle étant caractérisé en ce qu'il comporte une source de haute tension positive ($+U_A$) avec un condensateur réservoir ($C_R$) à ses bornes, des premiers moyens (D4 à D6) pour connecter, en parallèle sur la sortie du transformateur (TR), lesdits $n$ condensateurs (C1 à C3) en série dès que la tension sur cette sortie devient inférieure à ladite valeur prédéterminée ($-U_M$) et jusqu'à ce qu'elle atteigne sa valeur crête, des deuxièmes moyens (D1, D2, D7 à D9) pour connecter lesdits $n$ condensateurs en parallèle entre la source de haute tension positive ($+U_A$) et la sortie du transformateur dès que la tension de sortie lors du front arrière de l'impulsion devient supérieure à une seconde valeur prédéterminée ($-U_Q$), pour permettre la décharge des condensateurs, et des troisièmes moyens (D3, Z', r') pour limiter la tension de rebondissement, survenant à la fin du front arrière de l'impulsion, à une troisième valeur prédéterminée )$+U_l$) et arrêter ainsi la décharge des $n$ condensateurs à une valeur de charge ($U_{CO}$) égale à la différence entre la tension de la source de haute tension positive ($+U_A$) et ladite troisième valeur prédéterminée ($+U_l$).

2. Circuit de contrôle selon la revendication 1, caractérisé en ce que lesdits premiers moyens comprennent $n$ premières diodes (D4 à D6) constituant respectivement avec les $n$ condensateurs (C1 à C3) $n$ cellules comportant chacune en série un condensateur et une diode dont la cathode est reliée au condensateur, lesdites cellules étant connectées en série entre la sortie du transformateur d'impulsion (TR) et la masse de manière que le condensateur (C1) de la première cellule soit relié à ladite sortie tandis que l'anode de la diode (D6) de la dernière cellule est reliée à la masse, et en ce que lesdits deuxièmes moyens comprennent $n$ deuxièmes diodes (D7 à D9), dont les cathodes sont reliées à ladite source de haute tention ($+U_A$) et dont les anodes sont reliées respectivement aux cathodes des $n$ premières diodes (D4 à D6), et n-1 troisièmes diodes (D1, D2) connectées respectivement en parallèle sur les n-1 premières cellules, l'anode de chaque troisième diode étant reliée à l'extrémité côté condensateur de la cellule correspondante.

3. Circuit de contrôle selon la revendication 2, caractérisé en ce que lesdites troisièmes moyens comprennent un circuit limiteur de tension, composé d'une diode Zener (Z') en parallèle avec une résistance (r'), et une diode (D3) connectant une extrémité du circuit limiteur à l'extrémité non connectée à la masse de la dernière cellule, tandis que l'autre extrémité du circuit limiteur est reliée à la masse.

4. Circuit de contrôle selon l'une quelconque des revendications 1 à 3, caractérisé en ce que la tension positive de la source de haute tension +$U_A$ et la troisième valeur prédéterminée +$U_I$ sont choisies de manière que :

$$n (U_A - U_I) = U_M$$

où -$U_M$ est la valeur prédéterminée de la tension de sortie du transformateur à partir de laquelle la pente de l'impulsion est infléchie.

## Patentansprüche

1. Steuerschaltung für die Anstiegsflanke des an ein Magnetron eingegebenen Leistungsimpulses, mit einem Impulstransformator (TR) zum Liefern des Leistungsimpulses und mit einer Einrichtung, die mit dem Ausgang des Transformators (TR) verbunden ist, um die Steigung des Impulses ab einem vorgegebenen Wert der an diesem Ausgang anliegenden Spannung zu verändern, wobei die Einrichtung n Kondensatoren (C1 – C3) und Umschaltmittel (D4 – D6) umfaßt, mit denen die Kondensatoren (C1 – C3) parallel zum Ausgang des Transformators in Reihe geschaltet werden, wenn die Amplitude des Leistungsimpulses den vorgegebenen Wert erreicht, dadurch gekennzeichnet, daß sie eine Quelle hoher positiver Spannung (+$U_A$) mit einer an ihren Anschlüssen vorgesehenen Speicherkapazität ($C_R$), erste Mittel (D4 – D6), mit denen die in Reihe geschalteten n Kondensatoren (C1 – C3) parallel zum Ausgang des Transformators (TR) geschaltet werden, sobald die Spannung an diesem Ausgang kleiner als der vorgegebene Wert (-$U_M$) ist und solange, bis sie ihren Maximalwert erreicht, zweite Mittel (D1, D2, D7 – D9), mit denen die n Kondensatoren zwischen der Quelle hoher positiver Spannung (+$U_A$) und dem Ausgang des Transformators parallel geschaltet werden, sobald die Ausgangsspannung während der Abstiegsflanke des Impulses größer als ein zweiter vorgegebener Wert (-$U_Q$) ist, um die Entladung der Kondensatoren zu erlauben, und dritte Mittel (D3, Z', r'), mit denen die Überschwingspannung, die am Ende der Abstiegsflanke des Impulses auftritt, auf einen dritten vorgegebenen Wert (+$U_I$) begrenzt wird und so die Entladung der n Kondensatoren bei einem solchen Ladungswert ($U_{CO}$) beendet wird, der gleich dem Unterschied zwischen der Spannung der Quelle hoher positiver Spannung (+$U_A$) und dem dritten vorgegebenen Wert (+$U_I$) ist, umfaßt.

2. Steuerschaltung gemäß Anspruch 1, dadurch gekennzeichnet, daß die ersten Mittel n erste Dioden (D4 – D6) aufweisen, die jeweils mit den n Kondensatoren (C1 – C3) n Zellen ausbilden, die jeweils einen Kondensator und eine mit ihrer Kathode mit dem Kondensator in Reihe geschaltete Diode umfassen und jeweils mit dem Ausgang des Impulstransformators (TR) und der Masse so in Reihe geschaltet sind, daß der Kondensator (C1) der ersten Zelle mit dem Ausgang verbunden ist, während die Anode der Diode (D6) der letzten Zelle mit Masse verbunden ist, und daß die zweiten Mittel n zweite Dioden (D7 – D9), deren Kathoden mit der Quelle hoher Spannung (+$U_A$) und deren Anoden mit den entsprechenden Kathoden der n ersten Dioden (D4 – D6) verbunden sind, und n–1 dritte Dioden (D1, D2), die entsprechend mit den n–1 ersten Zellen parallel geschaltet sind, umfassen, wobei die Anoden einer jeden dritten Diode mit dem kondensatorseitigen Ende der entsprechenden Zelle verbunden ist.

3. Steuerschaltung gemäß Anspruch 2, dadurch gekennzeichnet, daß die dritten Mittel eine Spannungsbegrenzungsschaltung, die aus einer zu einem Widerstand (r') parallel geschalteten Zenerdiode (Z') aufgebaut ist, und eine Diode (D3), die ein Ende der Begrenzungsschaltung mit dem nicht mit Masse verbundenen Ende der letzten Zelle verbindet, umfassen, wobei das andere Ende der Begrenzungsschaltung mit Masse verbunden ist.

4. Steuerschaltung gemäß einem der Ansprüche 1 bis 3, dadurch gekennzeichnet, daß die positive Spannung der Quelle hoher Spannung +$U_A$ und der dritte vorgegebene Wert +$U_I$ auf folgende Weise gewählt werden:

$$n(U_A – U_I) = U_M$$

wobei -$U_M$ der vorgegebene Wert der Spannung am Ausgang des Transformators ist, von dem ab die Steigung des Impulses verändert wird.

## Claims

1. A controlling circuit for the formation edge of a power pulse applied to a magnetron, comprising a pulse transformer (TR) in order to supply the said power pulse and a device connected to the output of the said transformer (TR) in order to inflect the slope of the said pulse as from a predetermined value of the voltage at this output, said device comprising n capacitors (C1 through C3) and switching means (D4 through D6) in order to connect in parallel with the output of the said transformer, said capacitors (C1 through C3) in series, when the amplitude of the power pulse reaches the said predetermined value, the said controlling circuit being characterized in that it comprises a high positive voltage source (+$U_A$) with a buffer capacitor ($C_R$) at its terminals, first means (D4 through D6) in order to connect, in parallel at the output of the transformer (TR), the said n capacitors (C1 through C3) in series as soon as the voltage at this output is less than the said predetermined value (-$U_M$) and until it reaches its peak value, second means (D1, D2 and D7 through D9) for connecting the said n capacitors in parallel between the source of high voltage (+$U_A$) and the output of the transformer once the output voltage at the time of the rear edge of the pulse becomes greater than a second predetermined value (−$U_Q$), in order to permit the discharge of the capacitors, and third means (D3, Z' and r') in order to limit the rebound voltage, happening at the end of the rear edge of the pulse, at a third predetermined value (+$U_I$) and thus to stop discharge of the $n$ capacitors at a charge value ($U_{CO}$) equal to the difference between the voltage of the source of the high positive voltage (+$U_A$) and the said third predetermined value (+$U_I$).

2. The controlling circuit as claimed in claim 1, characterized in that the said first means comprise $n$ first diodes (D4 through D6) respectively constituting with the $n$ capacitors (C1 through C3) $n$ cells each comprising in series a capacitor and a diode whose cathode is connected to the capacitor, the said cells being connected in series between the output of the pulse transformer (TR) and ground in such a manner that the capacitor (C1) of the first cell is connected with the said output, whereas the anode of the diode (D6) of the last cell is connected with ground and in that the said second means comprise $n$ second diodes (D7 through D9), whose cathodes are connected with the said source of high voltage (+$U_A$) and whose anodes are connected respectively with the cathodes of the $n$ first diodes (D4 to D6), and n−1 third diodes (D1 and D2) respectively connected in parallel with the n−1 first cells, the anode of every third diode being connected with the end of the capacitor of the corresponding cell.

3. The controlling circuit as claimed in claim 2, characterized in that the said third means comprise a voltage limiting circuit made up of a Zener diode (Z') in parallel with a resistor (r') and a diode (D3) connecting one end of the limiting circuit with the end non-connected with the ground of the last cell, whereas the other end of the limiting circuit is connected with ground .

4. The controlling circuit as claimed in any one of the preceding claims 1 through 3, characterized in that the positive voltage of the high voltage source +$U_A$ and the third predetermined value +$U_I$ are selected in such a manner that:

$$n (U_A - U_I) = U_M$$

wherein −$U_M$ is the predetermined value of the output voltage of the transformer as from which the slope of the pulse is inflected.

Fig. 1

Fig. 2

Fig. 3